**Europäisches Patentamt**

**European Patent Office**

**Office européen des brevets**

(11) Veröffentlichungsnummer: **0 262 357 B1**

# EUROPÄISCHE PATENTSCHRIFT

(45) Veröffentlichungstag der Patentschrift: **01.04.92**

(51) Int. Cl.⁵: **G05F 3/20**

(21) Anmeldenummer: **87111703.2**

(22) Anmeldetag: **12.08.87**

(54) **Integrierte Schaltung in komplementärer Schaltungstechnik mit einem Substratvorspannungs-Generator.**

(30) Priorität: **30.09.86 DE 3633301**

(43) Veröffentlichungstag der Anmeldung:
**06.04.88 Patentblatt 88/14**

(45) Bekanntmachung des Hinweises auf die Patenterteilung:
**01.04.92 Patentblatt 92/14**

(84) Benannte Vertragsstaaten:
**AT DE FR GB IT NL SE**

(56) Entgegenhaltungen:
**EP-A- 0 175 152**
**EP-A- 0 202 074**
**EP-A- 0 217 065**
**US-A- 4 691 304**

(73) Patentinhaber: **SIEMENS AKTIENGESELL-SCHAFT**
**Wittelsbacherplatz 2**
**W-8000 München 2(DE)**

(72) Erfinder: **Winnerl, Josef, Dr.-Ing.**
**Schubertstrasse 2**
**W-8300 Landshut(DE)**
Erfinder: **Takàcs, Dezsö, Dipl.-Phys.**
**Annette-Kolb-Anger 7**
**W-8000 München 83(DE)**

## Beschreibung

Die Erfindung bezieht sich auf eine integrierte Schaltung in komplementärer Schaltungstechnik mit einem Substratvorspannungs-Generator nach dem Oberbegriff des Patentanspruchs 1.

Bei Schaltungen dieser Art liegt das Halbleitersubstrat nicht auf dem Massepotential $V_{SS}$ der Schaltung, sondern auf einer Substratvorspannung $V_{BB}$, die mittels eines Substratvorspannungs-Generators erzeugt wird. Bei einem Halbleitersubstrat aus p-leitendem Material, das mit einer eingefügten n-leitenden wannenförmigen Halbleiterzone versehen ist, handelt es sich dabei um eine negative Substratvorspannung von etwa -2 bis -3 Volt. Die Source-Gebiete von Feldeffekttransistoren, die außerhalb der wannenförmigen Halbleiterzone auf dem Halbleitersubstrat vorgesehen sind, sind hierbei auf das Massepotential $V_{SS}$ gelegt.

Im Moment des Einschaltens der positiven Versorgungsspannung $V_{DD}$ befindet sich das betrachtete p-leitende Halbleitersubstrat zunächst in einem Zustand des "floating", in dem es von äußeren Potentialen freigeschaltet ist. Dabei kann es über die Sperrschichtkapazitäten, die einerseits zwischen der wannenförmigen Halbleiterzone und dem Substrat und andererseits zwischen den mit dem Massepotential belegten Sourcegebieten und dem Substrat vorhanden sind, vorübergehend auf eine positive Vorspannung aufgeladen werden, die erst beim Wirksamwerden des Substratvorspannungs-Generators wieder abgebaut und durch die sich am Ausgang desselben allmählich aufbauende negative Substratvorspannung ersetzt wird. Positive Vorspannungen stellen aber ein hohes Sicherheitsrisiko für die integrierte Schaltung dar, da ein "latch-up"-Effekt ausgelöst werden kann, der im allgemeinen den Ausfall der integrierten Schaltung bedeutet.

Zum Verständnis des "latch-up"-Effekts kann man davon ausgehen, daß zwischen einem Anschluß eines in der wannenförmigen Halbleiterzone liegenden Feldeffekttransistors des ersten Kanaltyps und einem Anschluß eines außerhalb dieser Zone auf dem Halbleitersubstrat plazierten Feldeffekttransistors des zweiten Kanaltyps im allgemeinen vier aufeinanderfolgende Halbleiterschichten alternierender Leitfähigkeitstypen vorhanden sind, wobei das eine Anschlußgebiet des erstgenannten Transistors die erste Halbleiterschicht, die wannenförmige Halbleiterzone die zweite, das Halbleitersubstrat die dritte und das eine Anschlußgebiet des letzteren Transistors die vierte Halbleiterschicht bilden. Bei einer positiven Vorspannung des Halbleitersubstrats kann der pn-Übergang zwischen der dritten und vierten Halbleiterschicht so weit in Durchlaßrichtung vorgespannt werden, daß zwischen den genannten Transistoranschlüssen ein Strompfad entsteht, der auf eine parasitäre Thyristorwirkung innerhalb dieser Vierschichtenstruktur zurückzuführen ist. Der Strompfad bleibt dann auch nach einem Abbau der positiven Substratvorspannung bestehen und kann die integrierte Schaltung thermisch überlasten.

Eine integrierte Schaltung dieser Art, die zusätzlich mit Hilfe eines Steuerungsschaltkreises und eines Schalttransistors die Versorgungsspannung erst dann zuschaltet, wenn bereits eine Vorspannung gewünschter Polarität am Substrat anliegt, ist aus der europäischen Patentschrift EP-0 175 152 bekannt.

Der Erfindung liegt die Aufgabe zugrunde, eine Schaltung der eingangs genannten Art anzugeben, bei der das Auftreten von "latch-up"-Effekten weitgehend vermieden wird. Das wird erfindungsgemäß durch eine Ausbildung der Schaltung nach dem kennzeichnenden Teil des Patentanspruchs 1 erreicht.

Der mit der Erfindung erzielbare Vorteil liegt insbesondere darin, daß mit einfachen Mitteln verhindert wird, daß beim Einschalten der Versorgungsspannung das Halbleitersubstrat mit einer Vorspannung unerwünschter Polarität beaufschlagt wird, die einen "latch-up"-Effekt auslösen kann.

Die Patentansprüche 2 bis 7 sind auf bevorzugte Ausgestaltungen und Weiterbildungen der Erfindung gerichtet.

Die Erfindung wird nachfolgend anhand eines in der Zeichnung dargestellten bevorzugten Ausführungsbeispiels näher erläutert. Dabei zeigt:

Fig. 1  ein bevorzugtes Ausführungsbeispiel der Erfindung in teilweise schematischer Darstellung und

Fig. 2  eine zweckmäßige Ausbildung einer Teilschaltung von Fig. 1.

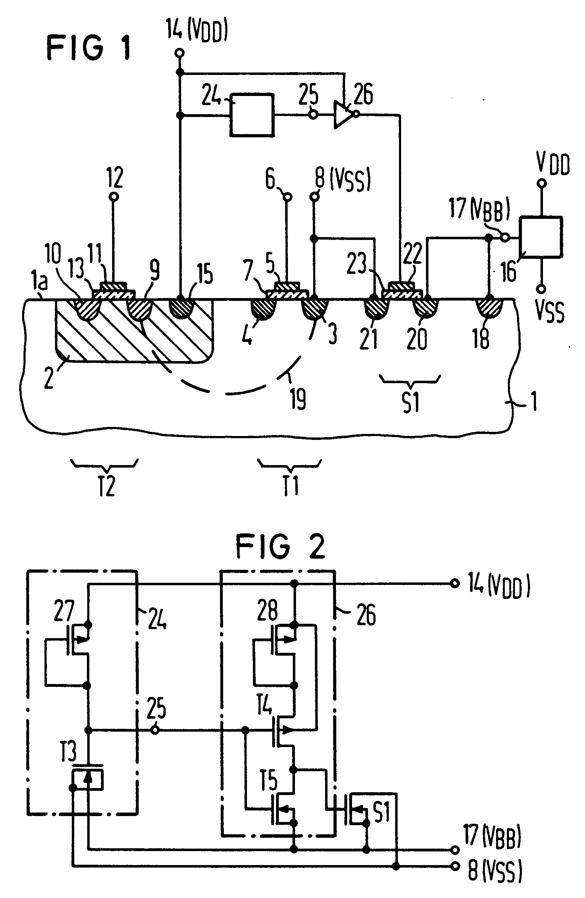

In Fig. 1 ist eine erfindungsgemäße integrierte Schaltung dargestellt, die auf einem Halbleitersubstrat 1 aus dotiertem Halbleitermaterial, zum Beispiel p-leitendem Silizium, aufgebaut ist. Das Substrat 1 weist eine n-leitende, wannenförmige Halbleiterzone 2 auf, die sich bis zur Grenzfläche 1a des Substrats 1 hin erstreckt. Außerhalb der Halbleiterzone 2 sind in das Substrat 1 $n^+$-dotierte Halbleitergebiete 3 und 4 eingefügt, die das Source- und Drain-Gebiet eines n-Kanal-Feldeffekttransistors T1 bilden. Der zwischen 3 und 4 liegende Kanalbereich wird von einem Gate 5 überdeckt, das mit einem Anschluß 6 versehen ist und durch eine dünne elektrisch isolierende Schicht 7, zum Beispiel aus $SiO_2$, von der Grenzfläche 1a getrennt ist. Das Source-Gebiet 3 ist mit einem Anschluß 8 verbunden, der auf einem Massepotential $V_{SS}$ liegt. Weiterhin sind in die Halbleiterzone 2 $p^+$-dotierte Gebiete 9 und 10 eingefügt welche das Source- und das Drain-Gebiet eines p-Kanal-Feldeffekttransistors T2 darstellen. Der zwischen den Gebieten 9 und 10 liegende Kanalbereich wird von einem Gate 11 überdeckt, das mit einem Anschluß 12 versehen ist und durch eine dünne elektrisch isolierende Schicht 13, zum Beispiel aus $SiO_2$, von der Grenzfläche 1a getrennt ist. Das Source-Gebiet 9 von T2 ist mit einem Anschluß 14 verbunden, der mit einem Versorgungspotential $V_{DD}$ beschaltet ist. Über ein $n^+$-dotiertes Kontaktgebiet 15, das mit dem Anschluß 14 in Verbindung steht, liegt die Halbleiterzone 2 auf der Versorgungsspannung $V_{DD}$.

Weiterhin ist ein Substratvorspannungs-Generator 16 vorgesehen, der eine negative Substratvorspannung von zum Beispiel -2 bis -3 Volt erzeugt. Der Ausgang 17 des Substratvorspannungs-Generators ist mit einem $p^+$-dotiertem Kontaktgebiet 18 verbunden, das in das Halbleitersubstrat 1 eingefügt ist. Damit befindet sich das Halbleitersubstrat 1 auf der durch 16 erzeugten negativen Substratvorspannung, während sich die Source-Gebiete, zum Beispiel 3, der im Halbleitersubstrat 1 befindlichen Transistoren, zum Beispiel T1, auf Massepotential $V_{SS}$ befinden. Hierdurch wird unter anderem erreicht, daß die Sperrschichtkapazitäten der Source-Gebiete der im Substrat 1 angeordneten Transistoren verkleinert werden.

Zur Vermeidung eines "latch-up"-Effekts, der innerhalb der entlang der gestrichelten Linie 19 zwischen den Anschlüssen 8 und 14 liegenden Vierschichtenstruktur 3, 1, 2 und 9 auftreten könnte, ist der Ausgang 17 des Substratvorspannungs-Generators 16 über einen elektronischen Schalter S1 mit einem Schaltungspunkt verbunden, der sich auf Massepotential befindet. Beim dargestellten Ausführungsbeispiel handelt es sich bei diesem Schaltungspunkt um den Anschluß 8. Im einzelnen ist der Ausgang 17 bei der Anordnung nach Figur 1 mit einem $n^+$-dotierten Halbleitergebiet 20 verbunden, das in das Halbleitersubstrat 1 eingefügt ist. Ein weiteres $n^+$-dotiertes, in das Halbleitersubstrat 1 eingefügtes Halbleitergebiet 21 ist mit dem auf Massepotential liegenden Schaltungspunkt, d. h. insbesondere mit dem Anschluß 8, verbunden. Der zwischen den Gebieten 20 und 21 liegende Bereich des Halbleitersubstrats 1 ist von einem Gate 22 überdeckt, das durch eine dünne elektrisch isolierende Schicht 23, zum Beispiel aus $SiO_2$, von der Grenzfläche 1a getrennt ist. Die Gebiete 20 und 21 bilden zusammen mit den Teilen 22 und 23 einen n-Kanal-Feldeffekt-Schalttransistor, der den elektronischen Schalter S1 darstellt.

Die Ansteuerung von S1 erfolgt über eine Verzögerungsschaltung 24, deren Eingang am Anschluß 14 liegt und deren Ausgang 25 über einen als Inverter ausgebildeten Verstärker 26 mit dem Gate 22 verbunden ist. Wird die Versorgungsspannung $V_{DD}$ über den Anschluß 14 bei Inbetriebnahme der Schaltung angelegt, so gibt der mit 14 verbundene Inverter 26 so lange einen hohen, etwa

$V_{DD}$ entsprechenden und den Schalter S1 in den leitenden Zustand versetzenden Ausgangspegel ab, als der Ausgang 25 von 24 auf dem im Ruhezustand vorhandenen Massepotential $V_{SS}$ verbleibt. Über S1 wird dabei der Ausgang 17 des Substratvorspannungs-Generators 16 und damit das Substrat 1 auf dem Massepotential $V_{SS}$ der Schaltung festgehalten. Erst wenn die Verzögerungsschaltung 24 nach einer vorgegebenen Verzögerungszeit auf die eingangsseitig angelegte Versorgungsspannung $V_{DD}$ insoweit reagiert, als sie über ihren Ausgang 25 einen Spannungspegel abgibt, der so groß ist, daß der Inverter 26 auf eine niedrige Ausgangsspannung umgeschaltet wird, sperrt der Schalter S1.

Die vorstehend beschriebene Ansteuerung von S1 bewirkt also, daß das Substrat 1 nach dem Anlegen der Versorgungsspannung während einer durch die Ausbildung der Verzögerungsschaltung 24 vorgegebenen Verzögerungszeit auf einem Potential liegt, daß dem Massepotential $V_{SS}$ entspricht. Erst nach dem Ablauf der Verzögerungszeit kann das Substrat 1 wegen des dann gesperrten Schalters S1 mit der vom Substratvorspannungs-Generator 16 gelieferten, über 17 und 18 zugeführten Vorspannung beaufschlagt werden. Bemißt man nun die Dauer der genannten Verzögerungszeit so, daß S1 erst dann gesperrt wird, wenn sich am Ausgang 17 von 16 die volle negative Vorspannung aufgebaut hat, ist die Gefahr des Auftretens eines "latch-up"-Effektes beim Anschalten der Versorgungsspannung beseitigt.

Fig. 2 zeigt eine bevorzugte und auf dem Halbleitersubstrat 1 in einfacher Weise zu integrierende Ausführungsform der Verzögerungsschaltung 24 und des Inverters 26 von Fig. 1. Dabei sind ein n-Kanal-Feldeffekttransistor T3 und ein Lastelement 27 vorgesehen, das insbesondere durch einen p-Kanal-Feldeffekttransistor gebildet wird, dessen Gate mit seinem Drainanschluß verbunden ist. Der Sourceanschluß dieses Transistors ist an den mit $V_{DD}$ belegten Anschluß 14 geführt, während sein Drainanschluß mit dem Gate von T3 verbunden ist. Die Source- und Drainanschlüsse von T3 sind dabei miteinander verbunden und an den auf Massepotential $V_{SS}$ liegenden Anschluß 8 geführt. Der als Kapazität wirkende Transistor T3 bildet zusammen mit dem Lastelement 27 ein RC-Glied, das eine besonders einfache Realisierung der Verzögerungsschaltung 24 darstellt. Der Ausgang 25 von 24 ist dann über den Verstärker 26 an das Gate des den Schalter S1 bildenden n-Kanal-Feldeffekttransistors gelegt. Der als Inverter ausgebildete Verstärker 26 enthält eine Serienschaltung eines p-Kanal-Feldeffekttransistors T4 und eines n-Kanal-Feldeffekttransistors T5, deren Gates mit dem Ausgang 25 beschaltet sind. Der obere Anschluß von T4 ist über ein Lastelement 28 mit 14 verbunden, der untere Anschluß von T5 mit dem Anschluß 17. Das Lastelement 28 ist zweckmäßig als p-Kanal-Feldeffekttransistor realisiert, dessen Gate mit seinem Drainanschluß beschaltet ist. Der elektronische Schalter S1 ist entsprechend Fig. 1 zwischen den Schaltungspunkten 17 und 8 eingefügt, wobei sein Gate mit dem Verbindungspunkt von T4 und T5 beschaltet ist. Wenn nach dem Anschalten von $V_{DD}$ an den Anschluß 14 die Spannung an 25 auf einen Wert angestiegen ist, der der Einsatzspannung von T5 entspricht, wird das Gate von S1 über den dann leitenden Transistor T5 auf die Spannung $V_{BB}$ gelegt, so daß S1 sperrt.

Der elektronische Schalter S1 kann abweichend von der bisher beschriebenen Ausführungsform auch in anderer Weise realisiert sein, zum Beispiel als bipolarer Transistor, der insbesondere als externes Schaltungselement ausgeführt und über Verbindungsleitungen an die Anschlüsse 8 und 17 geschaltet ist.

Neben den bisher behandelten Ausführungsformen umfaßt die Erfindung auch solche, bei denen n-leitende Substrate mit p-leitenden wannenförmigen Halbleiterzonen versehen sind. Dabei werden die Leitungstypen sämtlicher Halbleiterteile und die Polaritäten sämtlicher Spannungen durch die jeweils entgegengesetzten ersetzt.

Eine bevorzugte Anwendung der Erfindung ergibt sich für Peripherieschaltungen von dynamischen Halbleiterspeichern großer Packungsdichte, die mit den Speicherzellen monolithisch integriert sind.

**Patentansprüche**

1. Integrierte Schaltung in komplementärer Schaltungstechnik mit Feldeffekttransistoren (T1, T2) unterschiedlicher Kanaltypen, von denen wenigstens ein erster (T1) in einem dotierten Halbleitersubstrat (1) eines ersten Leitungstyps und wenigstens ein zweiter (T2) in einer im Halbleitersubstrat (1) vorgesehenen wannenförmigen Halbleiterzone (2) eines zweiten Leitungstyps angeordnet sind, wobei die Halbleiterzone mit einer Versorgungsspannung ($V_{DD}$) beschaltet ist, wobei ein Anschlußgebiet (3) wenigstens eines ersten Feldeffekttransistors (T1) mit einem Massepotential ($V_{SS}$) beaufschlagt ist und wobei das Halbleitersubstrat mit dem Ausgang (17) eines Substratvorspannungs-Generators (16) verbunden ist, dem das Massepotential und die Versorgungsspannung zugeführt werden und der den pn-Übergang zwischen dem auf Massepotential liegenden Anschlußgebiet des ersten Feldeffekttransistors und dem Halbleitersubstrat in Sperrrichtung vorspannt, **dadurch ge-**kennzeichnet, daß der Ausgang (17) des Substratvorspannungs-Generators (16) über einen elektronischen Schalter (S1) mit einem auf Massepotential liegenden Schaltungspunkt (8) verbunden ist und daß der elektronische Schalter über den Ausgang (25) einer mit der Versorgungsspannung ($V_{DD}$) beaufschlagten Verzögerungsschaltung (24) angesteuert wird.

2. Integrierte Schaltung nach Anspruch 1, **dadurch gekennzeichnet**, daß der Substratvorspannungs-Generator (16) auf dem Halbleitersubstrat (1) mit aufintegriert ist.

3. Integrierte Schaltung nach Anspruch 1 oder 2, **dadurch gekennzeichnet**, daß der Ausgang (17) des Substratvorspannungs-Generators (16) mit einem ersten in das Halbleitersubstrat eingefügten Halbleitergebiet (20) des zweiten Leitungstyps verbunden ist, daß in das Halbleitersubstrat ein zweites Halbleitergebiet (21) des zweiten Leitungstyps eingefügt ist, welches mit dem auf Massepotential liegenden Schaltungspunkt (8) verbunden ist, und daß ein zwischen diesen beiden Halbleitergebieten (20, 21) liegender Bereich des Halbleitersubstrats (1) von einem durch eine dünne elektrisch isolierende Schicht (23) von der Grenzfläche (1a) des Halbleitersubstrats getrennten Gate (22) überdeckt ist, welches zusammen mit den beiden Halbleitergebieten einen ersten Feldeffekt-Schalttransistor bildet, der den elektronischen Schalter (S1) darstellt.

4. Integrierte Schaltung nach einem der Ansprüche 1 bis 3, **dadurch gekennzeichnet**, daß die Verzögerungsschaltung (24) aus einem RC-Glied besteht, das einerseits mit einem mit der Versorgungsspannung ($V_{DD}$) beaufschlagten Anschluß (14) und andererseits mit dem auf Massepotential ($V_{SS}$) liegenden Schaltungspunkt (8) verbunden ist.

5. Integrierte Schaltung nach Anspruch 4, **dadurch gekennzeichnet**, daß das RC-Glied ein Lastelement (27) und einen Kondensator (T3) aufweist, wobei das Lastelement aus einem dritten Feldeffekttransistor besteht, dessen Gate mit seinem Drainanschluß verbunden ist, und der Kondensator (T3) aus einem vierten Feldeffekttransistor besteht, dessen Source- und Drainanschluß miteinander verbunden sind und einen ersten Kondensatoranschluß bilden, während der Gateanschluß den zweiten Kondensatoranschluß darstellt.

6. Integrierte Schaltung nach einem der Ansprüche 1 bis 5, **dadurch gekennzeichnet**, daß dem Ausgang (25) der Verzögerungsschaltung (24) ein invertierender Verstärker (26) nachgeschaltet ist, der eine Serienschaltung eines fünften und eines sechsten Feldeffekttransistors (T4, T5) enthält, die unterschiedlichen Kanaltypen angehören und deren Gates mit dem Ausgang (25) der Verzögerungsschaltung (24) verbunden sind, und daß die Serienschaltung einerseits über ein weiteres Lastelement mit der Versorgungsspannung (V$_{DD}$) beschaltet ist und andererseits mit dem Ausgang (17) des Substratvorspannungs-Generators (16) verbunden ist.

7. Anwendung einer integrierten Schaltung nach einem der vorhergehenden Ansprüche als Peripherieschaltung für dynamische Halbleiterspeicher hoher Integrationsdichte.

## Claims

1. Integrated circuit in complementary circuit technology comprising field-effect transistors (T1, T2) of different channel types, of which at least a first (T1) is disposed in a doped semiconductor substrate (1) of a first conductivity type and at least a second (T2) is disposed in a well-shaped semiconductor zone (2) of a second conductivity type provided in the semiconductor substrate (1), the semiconductor zone being wired to a supply voltage (V$_{DD}$) while an earth potential (V$_{SS}$) is applied to a terminal region (3) of at least one first field-effect transistor (T1), and the semiconductor substrate being connected to the output (17) of a substrate bias voltage generator (16) to which the earth potential and the supply voltage are supplied and which biases the p-n junction between the terminal region, situated at earth potential, of the first field-effect transistor and the semiconductor substrate in the reverse direction, characterised in that the output (17) of the substrate bias voltage generator (16) is connected to a circuit point (8) situated at earth potential via an electronic switch (S1), and in that the electronic switch is triggered via the output (25) of a delay circuit (24) to which the supply voltage (V$_{DD}$) is applied.

2. Integrated circuit according to Claim 1, characterised in that the substrate bias voltage generator (16) is also integrated on the semiconductor substrate (1).

3. Integrated circuit according to Claim 1 or 2, characterised in that the output (17) of the substrate bias voltage generator (16) is connected to a first semiconductor region (20) of the second conductivity type inserted in the semiconductor substrate, in that a second semiconductor region (21) of the second conductivity type which is connected to the circuit point (8) situated at earth potential 10 inserted in the semiconductor substrate, and in that a region of the semiconductor substrate (1) situated between these two semiconductor regions (20, 21) is covered by a gate (22) which is separated by a thin electrically insulating layer (23) from the boundary surface (1a) of the semiconductor substrate and which, together with the two semiconductor regions, forms a first field-effect switching transistor which represents the electronic switch (S1).

4. Integrated circuit according to one of Claims 1 to 3, characterised in that the delay circuit (24) comprises an RC element which is connected, on the one hand, to a terminal (14) to which the supply voltage (V$_{DD}$) is applied and, on the other hand, to the circuit point (8) situated at earth potential (V$_{SS}$).

5. Integrated circuit according to Claim 4, characterised in that the RC element contains a load element (27) and a capacitor (T3), the load element comprising a third field-effect transistor whose gate is connected to its drain terminal, and the capacitor (T3) comprising a fourth field-effect transistor whose source terminal and drain terminal are interconnected and form a first capacitor terminal, while the gate terminal represents the second capacitor terminal.

6. Integrated circuit according to one of Claims 1 to 5, characterised in that there is connected to the output (25) of the delay circuit (24) an inverting amplifier (26) which incorporates a series circuit of a fifth field-effect transistor (T4) and a sixth field-effect transistor (T5) which belong to different channel types and whose gates are connected to the output (25) of the delay circuit (24), and in that the series circuit is wired, on the one hand, to the supply voltage (V$_{DD}$) via a further load element and, on the other hand, is connected to the output (17) of the substrate bias voltage generator (16).

7. Use of an integrated circuit according to one of the preceding claims as a peripheral circuit for dynamic semiconductor stores of high integration density.

## Revendications

1. Circuit intégré réalisé selon la technique supplémentaire, comportant des transistors à effet de champ (T1,T2) possédant des types de canaux différents, parmi lesquels au moins un premier transistor (T1) est disposé dans un substrat semiconducteur dopé (1) possédant un premier type de conductivité et au moins un second transistor (T2) est disposé dans une région semiconductrice en forme de cuvette (2), prévue dans le substrat semiconducteur (1) et possédant un second type de conductivité, et dans lequel la région semiconductrice est placée à une tension d'alimentation ($V_{DD}$), une zone de raccordement (3) d'au moins un premier transistor à effet de champ (T1) est chargée par un potentiel de masse ($V_{SS}$) et le substrat semiconducteur est raccordé à la sortie (17) d'un générateur de tension de polarisation de substrat (16), auquel sont appliqués le potentiel de masse et la tension d'alimentation et qui polarise en inverse la jonction pn située entre la zone de raccordement, placée au potentiel de masse, du premier transistor à effet de champ et le substrat semiconducteur, caractérisé par le fait que la sortie (17) du générateur de tension de polarisation de substrat (16) est raccordée par l'intermédiaire d'un interrupteur électronique (S1) à un point (8) du circuit placé au potentiel de masse, et que l'interrupteur électronique est commandé au moyen de la sortie (25) d'un circuit de retardement (24) chargé par la tension d'alimentation ($V_{DD}$).

2. Circuit intégré suivant la revendication 1, caractérisé par le fait que le générateur de tension de polarisation de substrat (16) est conjointement intégré sur le substrat semiconducteur (1).

3. Circuit intégré suivant la revendication 1 ou 2, caractérisé par le fait que la sortie (17) du générateur de tension de polarisation de substrat (16) est raccordée à une première région semiconductrice (20) possédant le second type de conductivité et insérée dans le substrat semiconducteur, que dans le substrat semiconducteur est insérée une seconde région semiconductrice (21) possédant le second type de conductivité et qui est raccordée au point (8) du circuit placé au potentiel de masse, et qu'une région du substrat semiconducteur (1), située entre ces deux régions semiconductrices (20,21), est recouverte par une grille (22) qui est séparée de la surface limite (a) du substrat semiconducteur par une mince couche électriquement isolante (23) et forme, avec les deux régions semiconductrices, un premier transistor de commutation à effet de champ, qui représente l'interrupteur électronique (S1).

4. Circuit intégré suivant l'une des revendications 1 à 3, caractérisé par le fait que le circuit de retardement (24) est constitué par un circuit RC, qui est raccordé, d'une part, à une borne (14) chargée par la tension d'alimentation ($V_{DD}$), et, d'autre part, au point (8) du circuit, qui est placé au potentiel de masse ($V_{SS}$).

5. Circuit intégré suivant la revendication 4, caractérisé par le fait que le circuit RC comporte un élément de charge (27) et un condensateur (T3), l'élément de charge étant constitué par un troisième transistor à effet de champ, dont la grille est raccordée à la borne de drain, et le condensateur (T3) est constitué par un quatrième transistor à effet de champ, dont les bornes de source et de drain sont raccordées entre elles et forment une première borne d'un condensateur, tandis que la borne de grille forme la seconde borne du condensateur.

6. Circuit intégré suivant l'une des revendications 1 à 5, caractérisé par le fait qu'en aval de la sortie (25) du circuit de retardement (24) est branché un amplificateur inverseur (26), qui contient un circuit série formé d'un cinquième et d'un sixième transistor à effet de champ (T4,T5), qui ont des types de canaux différents et dont les grilles sont raccordées à la sortie (25) du circuit de retardement (24), et que le circuit série d'une part est placé à la tension d'alimentation ($V_{DD}$) par l'intermédiaire d'un autre élément de charge et d'autre part est raccordé à la sortie (17) du générateur de tension de polarisation de substrat (16).

7. Utilisation d'un circuit intégré suivant l'une des revendications précédentes en tant que circuit périphérique pour des mémoires dynamiques à semiconducteurs à haute densité d'intégration.

## FIG 1

## FIG 2